# EUROPEAN PATENT SPECIFICATION

(11) **EP 3 334 254 B1**
(45) Date of publication and mention of the grant of the patent: **15.07.2020**
(21) Application number: 17204925.6
(22) Date of filing: 01.12.2017
(51) Int. Cl.: H01G 9/00, H01G 9/08, H01G 4/40, H01G 2/06, H01G 2/08, H01G 4/224, H01G 4/258, H05K 1/02, H05K 1/18, H05B 45/00, F21Y 115/10, H01G 9/28

(54) **ELECTRIC DRIVER AND ILLUMINATION DEVICE**
ELEKTRISCHER TREIBER UND BELEUCHTUNGSVORRICHTUNG
CONDUCTEUR ÉLECTRIQUE ET DISPOSITIF D'ÉCLAIRAGE

(30) Priority: 06.12.2016 CN 201621329196 U
(43) Date of publication of application: 13.06.2018
(73) Proprietor: OSRAM GmbH, 80807 München (DE)
(72) Inventor: ZHUANG, XiHe, Shenzhen, Guangdong 518053 (CN); Gao, Jianbo, Shenzhen, Guangdong 518053 (CN); TAN, Wengen, Shenzhen, Guangdong 518053 (CN); HUANG, Yizhi, Shenzhen, Guangdong 518053 (CN)

(56) References cited:
- EP-A1- 1 720 182
- JP-A- 2012 064 842

## Description

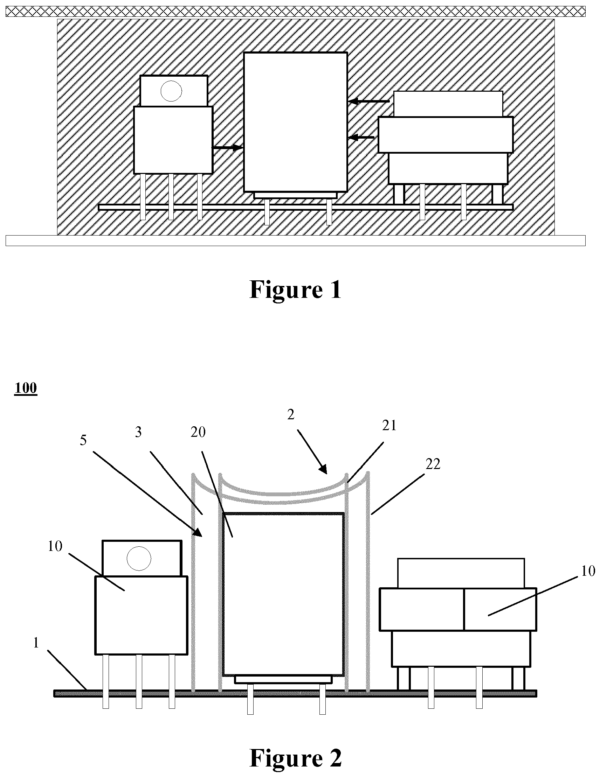

The present disclosure relates to an electric driver and an illumination device. Since LED light sources have high illumination efficiency, the LED illumination technique is tremendously used in illumination devices. A driver of an LED illumination device are generally provided with a variety of electrical components, comprising a capacitor, an electrolytic capacitor (E-cap) and a metallized polypropylene film capacitor (MKP cap) in particular, and other components. Those components are enveloped by an potting material so as to improve the thermal conductivity and airtightness of a high power LED driver. For example, as shown in figure 1, a schematic diagram of an electric driver according to the prior art is shown in figure 1, wherein the arrows show the directions of heat conducted between electrical components. The electric driver comprises a variety of electrical components provided on a circuit board. According to the design in figure 1, heat generated by power components (for example, a transformer, MOSFET, and a rectifier) can be easily conducted and the heat is dissipated.

However, since other electrical components of the electric driver are all assembled in the proximity of capacitors, heat from other electrical components, for example, the heat from MOSFET and the transformer, will be easily conducted to the capacitors, and the temperature of the capacitors having less heat will become higher due to the heat conducted from other electrical components. The lifetime of capacitors is quite easily influenced by the temperature, and moreover, the lifetime of capacitors will be reduced by 50% with the temperature increased by 10°C each time. After the potting material is used, the heat will be easily and rapidly conducted to the capacitors, which further quickens the damage on the capacitors. In the prior art, in order to prolong the lifetime of capacitors, capacitors having a long lifetime and a high rated temperature are used on the one hand, whereas such capacitors are costly; plastic housings are used for wrapping the capacitors one the other hand, whereas the plastic housings are costly. Moreover, in order to fix the plastic housings on the circuit board, the circuit board must be provided with special mounting holes, which not only occupies space, and increases the product volume, but also increases difficulties in product design.

Since LED light sources have high illumination efficiency, the LED illumination technique is tremendously used in illumination devices. A driver of an LED illumination device are generally provided with a variety of electrical components, comprising a capacitor, an electrolytic capacitor (E-cap) and a metallized polypropylene film capacitor (MKP cap) in particular, and other components. Those components are enveloped by an potting material so as to improve the thermal conductivity and airtightness of a high power LED driver. For example, as shown in figure 1, a schematic diagram of an electric driver according to the prior art is shown in figure 1, wherein the arrows show the directions of heat conducted between electrical components. The electric driver comprises a variety of electrical components provided on a circuit board. According to the design in figure 1, heat generated by power components (for example, a transformer, MOSFET, and a rectifier) can be easily conducted and the heat is dissipated.

JP 2012064842 A discloses an electrolytic capacitor with an electrical insulating and thermal dissipating structure to keep the electrolytic capacitor cool and electrically insulated. To achieve this, a insulative heat radiation composition layer is provided on a surface of a metal case.

However, since other electrical components of the electric driver are all assembled in the proximity of capacitors, heat from other electrical components, for example, the heat from MOSFET and the transformer, will be easily conducted to the capacitors, and the temperature of the capacitors having less heat will become higher due to the heat conducted from other electrical components. The lifetime of capacitors is quite easily influenced by the temperature, and moreover, the lifetime of capacitors will be reduced by 50% with the temperature increased by 10°C each time. After the potting material is used, the heat will be easily and rapidly conducted to the capacitors, which further quickens the damage on the capacitors. In the prior art, in order to prolong the lifetime of capacitors, capacitors having a long lifetime and a high rated temperature are used on the one hand, whereas such capacitors are costly; plastic housings are used for wrapping the capacitors one the other hand, whereas the plastic housings are costly. Moreover, in order to fix the plastic housings on the circuit board, the circuit board must be provided with special mounting holes, which not only occupies space, and increases the product volume, but also increases difficulties in product design.

In order to solve the above-mentioned technical problem, the present disclosure provides a new electric driver and an illumination device. The electric driver and the illumination device according to the present disclosure can effectively decrease the temperature of capacitors, thereby improving the lifetime of the capacitors, and moreover, they have low costs, and can be easily assembled and have compact structures.

The object of the present invention is realized by means of such an electric driver, i.e., an electric driver comprising: a carrier; a first electrical component and a second electrical component, wherein the first electrical component and the second electrical component are provided on the carrier; and a heat insulation structure, wherein the second electrical component is separated from the first electrical component by means of the heat insulation structure, wherein the heat insulation structure comprises a first heat insulator surrounding the second electrical component and a second heat insulator surrounding the first heat insulator, wherein a gap is provided between the first heat insulator and a second heat insulator.

According to the electric driver of the present invention, a gap is intentionally provided between a plurality of electrical components by means of the heat insulation structure, particularly, for example, between a low-temperature capacitor and a high-temperature high-power component. A gap can advantageously reduce or prevent heat conducted from the high-temperature high-power component to the low-temperature capacitor, and avoid the capacitor from becoming hotter due to the conducted heat. The heat insulation structure has a simple and compact structure, and features low costs and convenient assembly, wherein the first heat insulator can directly mounted and fixed onto the second electrical component, and the second heat insulator can be further provided in the periphery of the first heat insulator.

According to a preferable embodiment in the present invention, the first electrical component is enveloped by the first medium, the second electrical component is separated from the first medium by means of a gap, and moreover, the second medium is provided in the gap, wherein the second medium has a thermal resistance greater than that of the first medium. The thermal conductivity and airtightness of the first electrical component are improved by enveloping the first electrical component by means of the first medium. However, the gap provided can advantageously reduce or prevent heat being directly conducted from the high-temperature first electrical component to the second electrical component by means of the heat conducted first medium, and thus avoids the second electrical component from increasing temperatures due to the conducted heat, and improves the lifetime of the second electrical component.

According to a preferable embodiment of the present invention, the electric driver further comprises a housing, wherein the carrier, the first electrical component, and the second electrical component are provided in the housing. The first electrical component and the carrier are encapsulated by filling the first medium in the housing, and the heat from electrical components can be conducted to the housing by means of the heat conducted potting material, and hereby dissipating the heat.

According to a preferable embodiment of the invention, the first electrical component is connected to the housing by means of the first medium, and the second electrical component is connected to the housing by means of the second medium. The heat from the first electrical component is directly conducted to the housing by means of the first medium, and the heat therefrom is thereby dissipated by means of the housing; on the other hand, the heat from the second electrical component is directly conducted to the housing by means of the second medium, and the heat therefrom is thereby dissipated by means of the housing.

According to a preferable embodiment of the invention, the electric driver further comprises a thermal pad, wherein the end of the second electrical component facing away from the carrier is thermally connected to the housing by means of the thermal pad. For example, the first medium of the potting material is not provided on the top of a capacitor, whereas a thermal pad is provided between the top of the capacitor and the housing, which results in a low temperature of the housing, and reduces the temperature of the capacitor.

According to a preferable embodiment of the invention, the first medium is potting material, and the second medium is air. The first medium enhances the air-tightness and thermal conductivity of the first electrical component, and the second medium has a heat resistance greater than that of the first medium, which particularly reduces or prevents the heat from the first electrical component from being conducted to the second electrical component.

According to a preferable embodiment the first electrical component has higher rated temperature than that of the second electrical component. The first electrical component is generally a high power electrical component with high rated temperature, such as MOSFET, a transformer, and a rectifier.

According to a preferable embodiment, the first heat insulator and the second heat insulator are made of polyethylene terephthalate or fish paper. Materials such as fish paper are used to avoid high costs incurred from needs of using a special mold for manufacturing a plastic housing. Materials such as fish paper require no mold since fish paper is cheap, and is also a commonly used material.

According to a preferable embodiment, the second electrical component is a capacitor. Preferably, the capacitor is an electrolytic capacitor, and the capacitor has a rated operating temperature lower than that of high-power components.

Another object of the present invention is realized by means of such an illumination device, i.e., an illumination device comprising the electric driver as described in the preceding text. The illumination device according to the present invention has an electric driver which operates more stably and reliably. Moreover, due to the low cost of the electric driver, the cost for manufacturing the illumination device is thereby reduced.

The drawings constitute a portion of the description for further understanding of the present invention. These drawings illustrate the embodiments of the present invention and explain the principle of the present invention together with the description. In the drawings, the same part is represented by the same reference sign. In the drawings,
Fig. 1 shows a schematic diagram of the electric driver according to the prior art;
Fig. 2 shows a schematic diagram of the electric driver according to example 1 of the present invention;
Fig. 3 shows a schematic diagram of the electric driver according to example 2 of the present invention; and
Fig.4 shows a schematic diagram of the electric driver according to example 3 of the present invention.
Fig. 2 shows a schematic diagram of the electric driver 100 according to example 1 of the present invention. The electric driver 100 comprises: a first electrical component 10 and a second electrical component 20, a carrier 1 for bearing the first electrical component 10 and the second electrical component 20, and a heat insulation structure 2; wherein the second electrical component 20 is separated from the first electrical component 10 by means of the heat insulation structure 2, wherein the heat insulation structure 2 comprises a first heat insulator 21 surrounding the second electrical component 20 and a second heat insulator 22 surrounding the first heat insulator 21, wherein a gap 3 is provided between the first heat insulator 21 and a second heat insulator 22.

Preferably, the first electrical component 10 can be designed to be an electrical component having a high rated temperature and power, such as MOSFET, a transformer, and a rectifier. The second electrical component 20 can be designed to be an electrical component having a low rated temperature and power, such as an electrolytic capacitor. The carrier 1 can be a printed circuit board which electrically and mechanically connects the first electrical component 10 with the second electrical component 20.

Preferably, the heat insulation structure 2 can be made of two layers of insulation sheet with the first layer of insulation sheet directly mounted and fixed on the second electrical component 20 and with the second layer of insulation sheet surrounding the first layer of insulation sheet, and thereby forming, around the second electrical component 20, the gap 3 separated from the first electrical component 10. The insulation sheets can be made of polyethylene terephthalate (PET) or fish paper. Air is provided between the two layers of insulation sheets. When the first electrical component 10 and the second electrical component 20 are assembled on the same carrier 1, the heat of the first electrical component 10 may be conducted to the second electrical component 20. To that end, the second electrical component 20 is separated from the first electrical component 10 by means of the heat insulation structure 2. Accordingly, the heat of the first electrical component 10 will not be directly conducted to the second electrical component 20. Thus, the temperature of the second electrical component 20 will not be increased due to the heat from the first electrical component 10, which particularly improves the lifetime of the second electrical component 20.

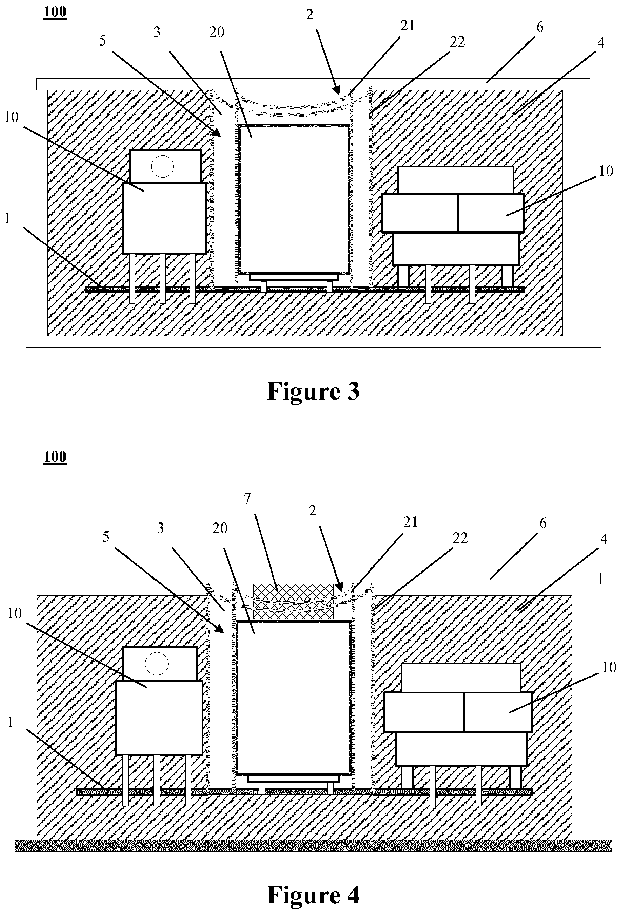

Fig. 3 shows a schematic diagram of the electric driver 100 according to example 2 of the present invention. The electric driver 100 comprises: a first electrical component 10 and the second electrical component 20, a carrier 1 for bearing the electrical component 10 and the second electrical component 20, and a heat insulation structure 2; the above-mentioned components have structures and functions the same that disclosed in example 1. In addition, the electric driver 100 further comprises a housing 6 for holding the first electrical component 10, the second electrical component 20, and the carrier 1. The housing 6 can be filled with an potting material serving as a first medium 4 and made of, for example, silicon resin or asphalt, and such an potting material is used for sealing at least the first electrical component 10 such that the electrical component is waterproof and dustproof, which ensures that the electrical component is not influenced by the environment outside the housing 6. A second medium 5 having a heat resistance greater than that of the first medium 4, for example, air, is provided between two layers of insulation sheet as a heat insulation structure 2. The second electrical component 20, by means of the heat insulation structure 2, is separated from the first electrical component 10 and the first medium 4 enveloping the first electrical component 10. Accordingly, the heat of the first electrical component 10 will not be directly conducted to the second electrical component 20 or directly conducted to the second electrical component 20 by means of a heat conducted potting material.

In example 2, as shown in Fig. 3, for example, in a vertical direction of the carrier 1, the potting material is filled between the first electrical component 10 and the housing 6. Accordingly, the heat of the first electrical component 10 can be directly conducted to the housing 6 by means of the potting material, and heat is further dissipated by means of the housing 6. Thus, the heat conduction and dissipation performance of the first electrical component is thereby improved. Upon comparison, no potting material is filled between one end of the second electrical component 20 deviating from the carrier 1 and the housing 6, which causes that the heat of the second electrical component 20 substantially is not conducted by means of the potting material, but conducted to the housing 6 by means of air in the gap 3. Therefore, the heat conducted by the second electrical component 20 to the housing is reduced, the temperature of the housing is further reduced, and the stability of the whole driver is guaranteed.

Fig.4 shows a schematic diagram of the electric driver according to example 3 of the present invention. Example 3 differs from example 2 in that in a vertical direction of the carrier 1, no potting material is filled between the first electrical component 10 and the housing 6, which advantageously reduces the heat conducted from the first electrical component 10 to the housing 6, thereby reducing the temperature of the housing 6 when the airtightness of the first electrical component 10 is ensured simultaneously.

A thermal pad 7, for example, heat conductive silicone, is further provided between the second electrical component 20 and the housing 6. The thermal pad 7 is particularly provided at one end or top of the second electrical component 20 deviating from the carrier 1, and accordingly, the heat from the second electrical component 20 can be conducted to the housing 6 by means of the thermal pad 7 and the heat is dissipated by means of the housing 6, which further reduces the temperature of the second electrical component 20. In addition, the embodiment of the thermal pad 7 in example 3 as shown in Fig.4 can be similarly applied to example 2 as shown in Fig.3 so as to realize highly efficient heat dissipation and rapid temperature reduction of the second electrical component 20, and prolong the lifetime thereof.

### LIST OF REFERENCE SIGNS

- 1: carrier
- 2: heat insulation structure
- 3: gap
- 4: first medium
- 5: second medium
- 6: housing
- 7: thermal pad
- 10: first electrical component
- 20: second electrical component
- 21: first heat insulator
- 22: second heat insulator
- 100: electric driver

## Claims

1. An electric driver (100), comprising:
a carrier (1);
a first electrical component (10) and a second electrical component (20), wherein the first electrical component (10) and the second electrical component (20) are provided on the carrier (1); and
a heat insulation structure (2), wherein the second electrical component (20) is separated from the first electrical component (10) by means of the heat insulation structure (2), **characterized in that** the heat insulation structure (2) comprises a first heat insulator (21) surrounding the second electrical component (20) and a second heat insulator (22) surrounding the first heat insulator (21), wherein a gap (3) is provided between the first heat insulator (21) and a second heat insulator (22).

2. The electric driver (100) according to claim 1, **characterized in that** the first electrical component (10) is enveloped by a first medium (4), the second electrical component (20) is separated from the first medium (4) by the heat insulation structure (2), wherein a second medium (5) is provided in the gap (3), wherein the second medium (5) has a thermal resistance greater than that of the first medium (4).

3. The electric driver (100) according to claim 2, **characterized in that** the electric driver (100) further comprises a housing (6), wherein the carrier (1), the first electrical component (10) and the second electrical component (20) are provided in the housing (6).

4. The electric driver (100) according to claim 3, **characterized in that** the first electrical component (10) is connected to the housing (6) by means of the first medium (4), and the second electrical component (20) is connected to the housing (6) by means of the second medium (5).

5. The electric driver (100) according to claim 3 or 4, **characterized in that** the electric driver (100) further comprises a thermal pad (7), wherein the end of the second electrical component (20) facing away from the carrier (1) is thermally connected to the housing (6) by means of the thermal pad (7).

6. The electric driver (100) according to any one of claims 1-4, **characterized in that** the first medium (4) is potting material and the second medium (5) is air.

7. The electric driver (100) according to any one of claims 1-4, **characterized in that** the first electrical component (10) has higher rated temperature than that of the second electrical component (20).

8. The electric driver (100) according to any one of claims 1-4, **characterized in that** the first heat insulator (21) and the second heat insulator (22) are made of polyethylene terephthalate or fish paper.

9. The electric driver (100) according to any one of claims 1-4, **characterized in that** the second electrical component (20) is a capacitor.

10. An illumination device, **characterized in** comprising the electric driver (100) according to any one of claims 1-9.

## Patentansprüche

1. Elektrischer Treiber (100), umfassend:
einen Träger (1);
eine erste elektrische Komponente (10) und eine zweite elektrische Komponente (20), wobei die erste elektrische Komponente (10) und die zweite elektrische Komponente (20) auf dem Träger (1) bereitgestellt werden; und
eine Wärmeisolierstruktur (2), wobei die zweite elektrische Komponente (20) von der ersten elektrischen Komponente (10) mittels der Wärmeisolierstruktur (2) getrennt ist, **dadurch gekennzeichnet, dass** die Wärmeisolierstruktur (2) einen ersten Wärmeisolator (21), der die zweite elektrische Komponente (20) umgibt, und einen zweiten Wärmeisolator (22) umfasst, der den ersten Wärmeisolator (21) umgibt, wobei zwischen dem ersten Wärmeisolator (21) und einem zweiten Wärmeisolator (22) eine Lücke (3) bereitgestellt wird.

2. Elektrischer Treiber (100) nach Anspruch 1, **dadurch gekennzeichnet, dass** die erste elektrische Komponente (10) von einem ersten Medium (4) umhüllt ist, die zweite elektrische Komponente (20) von dem ersten Medium (4) durch die Wärmeisolierstruktur (2) getrennt ist, wobei ein zweites Medium (5) in der Lücke (3) bereitgestellt wird, wobei das zweite Medium (5) einen thermischen Widerstand aufweist, der größer als derjenige des ersten Mediums (4) ist.

3. Elektrischer Treiber (100) nach Anspruch 2, **dadurch gekennzeichnet, dass** der elektrische Treiber (100) des Weiteren ein Gehäuse (6) umfasst, wobei der Träger (1), die erste elektrische Komponente (10) und die zweite elektrische Komponente (20) in dem Gehäuse (6) bereitgestellt werden.

4. Elektrischer Treiber (100) nach Anspruch 3, **dadurch gekennzeichnet, dass** die erste elektrische Komponente (10) mittels des ersten Mediums (4) mit dem Gehäuse (6) verbunden ist und die zweite elektrische Komponente (20) mittels des zweiten Mediums (5) mit dem Gehäuse (6) verbunden ist.

5. Elektrischer Treiber (100) nach Anspruch 3 oder 4, **dadurch gekennzeichnet, dass** der elektrische Treiber (100) des Weiteren eine Wärmefalle (7) umfasst, wobei das Ende der zweiten elektrischen Komponente (20), das von dem Träger (1) weg weist, thermisch mittels der Wärmefalle (7) mit dem Gehäuse (6) verbunden ist.

6. Elektrischer Treiber (100) nach einem der Ansprüche 1 bis 4, **dadurch gekennzeichnet, dass** das erste Medium (4) Vergussmaterial ist und das zweite Medium (5) Luft ist.

7. Elektrischer Treiber (100) nach einem der Ansprüche 1 bis 4, **dadurch gekennzeichnet, dass** die erste elektrische Komponente (10) eine höhere Nenntemperatur als die zweite elektrische Komponente (20) hat.

8. Elektrischer Treiber (100) nach einem der Ansprüche 1 bis 4, **dadurch gekennzeichnet, dass** der erste Wärmeisolator (21) und der zweite Wärmeisolator (22) aus Polyethylenterephthalat oder Fischpapier gefertigt sind.

9. Elektrischer Treiber (100) nach einem der Ansprüche 1 bis 4, **dadurch gekennzeichnet, dass** die zweite elektrische Komponente (20) ein Kondensator ist.

10. Beleuchtungsvorrichtung, **dadurch gekennzeichnet, dass** sie den elektrischen Treiber (100) nach einem der Ansprüche 1 bis 9 umfasst.

## Revendications

1. Pilote électrique (100), comprenant :
un support (1) ;
un premier composant électrique (10) et un deuxième composant électrique (20), dans lequel le premier composant électrique (10) et le deuxième composant électrique (20) sont prévus sur le support (1) ; et
une structure d'isolation thermique (2), dans lequel le deuxième composant électrique (20) est séparé du premier composant électrique (10) au moyen de la structure d'isolation thermique (2), **caractérisé en ce que** la structure d'isolation thermique (2) comprend un premier isolant thermique (21) entourant le deuxième composant électrique (20) et un deuxième isolant thermique (22) entourant le premier isolant thermique (21), dans lequel un écart (3) est prévu entre le premier isolant thermique (21) et un deuxième isolant thermique (22).

2. Pilote électrique (100) selon la revendication 1, **caractérisé en ce que** le premier composant électrique (10) est enveloppé par un premier milieu (4), le deuxième composant électrique (20) est séparé du premier milieu (4) par la structure d'isolation thermique (2), dans lequel un deuxième milieu (5) est prévu dans l'écart (3), dans lequel le deuxième milieu (5) a une résistance thermique supérieure à celle du premier milieu (4).

3. Pilote électrique (100) selon la revendication 2, **caractérisé en ce que** le pilote électrique (100) comprend en outre un boîtier (6), dans lequel le support (1), le premier composant électrique (10) et le deuxième composant électrique (20) sont prévus dans le boîtier (6).

4. Pilote électrique (100) selon la revendication 3, **caractérisé en ce que** le premier composant électrique (10) est relié au boîtier (6) au moyen du premier milieu (4), et le deuxième composant électrique (20) est relié au boîtier (6) au moyen du deuxième milieu (5).

5. Pilote électrique (100) selon la revendication 3 ou 4, **caractérisé en ce que** le pilote électrique (100) comprend en outre un tampon thermique (7), dans lequel l'extrémité du deuxième composant électrique (20) opposée au support (1) est thermiquement reliée au boîtier (6) au moyen du tampon thermique (7).

6. Pilote électrique (100) selon l'une quelconque des revendications 1 à 4, **caractérisé en ce que** le premier milieu (4) est un matériau de remplissage et le deuxième milieu (5) est de l'air.

7. Pilote électrique (100) selon l'une quelconque des revendications 1 à 4, **caractérisé en ce que** le premier composant électrique (10) a une température nominale supérieure à celle du deuxième composant électrique (20).

8. Pilote électrique (100) selon l'une quelconque des revendications 1 à 4, **caractérisé en ce que** le premier isolant thermique (21) et le deuxième isolant thermique (22) sont réalisés en polyéthylène téréphtalate ou en papier isolant.

9. Pilote électrique (100) selon l'une quelconque des revendications 1 à 4, **caractérisé en ce que** le deuxième composant électrique (20) est un condensateur.

10. Dispositif d'éclairage, **caractérisé en ce qu'**il comprend le pilote électrique (100) selon l'une quelconque des revendications 1 à 9.
